# EUROPEAN PATENT APPLICATION

(11) **EP 2 736 251 A1**
(43) Date of publication of application: **28.05.2014**
(21) Application number: 12817699.7
(22) Date of filing: 23.07.2012
(51) Int. Cl.: H04N 7/08, H04N 13/00

(54) **TRANSMITTING APPARATUS, RECEIVING APPARATUS, AND TRANSCEIVING METHOD THEREFOR**

(30) Priority: 22.07.2011 US 201161510658 P; 29.07.2011 US 201161513044 P; 20.07.2012 KR 20120079562
(71) Applicant: Samsung Electronics Co., Ltd., Suwon-si, Gyeonggi-do, 443-742 (KR)
(72) Inventor: PARK, Hong-seok, Anyang-si Gyeonggi-do 431-050 (KR); KIM, Yong-je, Yongin-si Gyeonggi-do 448-785 (KR); KIM, Hee-jean, Yongin-si Gyeonggi-do 449-905 (KR); JOO, Seong-sin, Seoul 135-841 (KR); LEE, Dae-jong, Hwaseong-si Gyeonggi-do 445-738 (KR); LEE, Jae-jun, Suwon-si Gyeonggi-do 443-769 (KR); JANG, Yong-seok, Hwaseong-si Gyeonggi-do 487-851 (KR); JOO, Yu-sung, Yongin-si Gyeonggi-do 448-130 (KR)
(74) Representative: Walaski, Jan Filip
(86) International application number: PCT/KR2012/005859
(87) International publication number: WO 2013/015585

(57) **Abstract**

Disclosed is a transmitting apparatus. The transmitting apparatus comprises: a down-scaler for down-scaling multimedia data; a first encoder for encoding the down-scaled multimedia data; a first transmitting unit for transmitting the encoded multimedia data through a first transmitting network; a decoder for decoding the encoded multimedia data; an up-scaler for up-scaling the decoded multimedia data; a restoration data generating unit for generating restoration data using the up-scaled multimedia data; a second encoder for encoding the restoration data; and a second transmitting unit for transmitting the encoded restoration data through a second transmitting network.

## Description

### CROSS-REFERENCE TO RELATED APPLICATIONS

This application claims priority from Korean Patent Application No. 10-2012-0079562, filed on July 20, 2012, in the Korean Intellectual Property Office, the disclosure of which is incorporated herein by reference in its entirety.

### BACKGROUND OF THE INVENTION

### Field of the Invention

The present invention relates to a transmitting apparatus, a receiving apparatus, and a transceiving method therefor, and more particularly, to a transmitting apparatus for providing a plurality of streams, a receiving apparatus for receiving and processing a plurality of streams, and a transceiving method therefor.

### Description of the Related Art

By virtue of recent development of electronic technologies, various types of electronic devices have been developed and spread. In particular, televisions (TVs) may provide three-dimensional (3D) content or high resolution content. Accordingly, broadcast technologies have been developed for content including a plurality of images, for example, 3D content, multi-angle content, and content including a depth image, or ultra high definition (UHD) image quality content.

A channel bandwidth used in a conventional broadcast network is limited. On the other hand, multi-angle content, 3D content, UHD image quality content, etc. have a large data size than conventional content. Thus, it is difficult to transmit content with a large data size via a conventional broadcast network without change.

It is difficult to invest in new equipment in terms of costs in order to provide new content. Thus, there is a need for a method of providing new content using conventional broadcast equipment and receiving apparatus.

### SUMMARY OF THE INVENTION

Exemplary embodiments of the present invention overcome the above disadvantages and other disadvantages not described above. Also, the present invention is not required to overcome the disadvantages described above, and an exemplary embodiment of the present invention may not overcome any of the problems described above. The present invention provides a transmitting apparatus for providing a plurality of streams, a receiving apparatus for receiving and processing a plurality of streams, and a transceiving method therefor.

According to an aspect of the present invention, a transmitting apparatus includes a down-scaler configured to down-scale multimedia data, a first encoder configured to encode the down-scaled multimedia data, a first transmitter configured to transmit the encoded multimedia data through a first transmission network, a decoder configured to decode the encoded multimedia data, an up-scaler configured to up-scale the decoded multimedia data, a restoration data generator configured to generate restoration data using the up-scaled multimedia data, a second encoder configured to encode the restoration data, and a second transmitter configured to transmit the encoded restoration data through a second transmission network.

The multimedia data may be 2D content data, and the restoration data generator may compare the 2D content data and the up-scaled 2D content data to generate a comparison result as the restoration data.

The multimedia data may be one of left eye image data and right eye image data contained in 3D content, and the restoration data generator may compare another one of the left eye image data and the right eye image data with the up-scaled multimedia data to generate a comparison result as the restoration data.

The first transmission network may be a radio frequency (RF) network, and the second transmission network may be an Internet protocol (IP) network.

According to another aspect of the present invention, a receiving apparatus includes a first receiver configured to receive multimedia data transmitted through a first transmission network, a first decoder configured to decode the received multimedia data, an up-scaler configured to up-scale the decoded multimedia data, a second receiver configured to receive restoration data transmitted through a second transmission network, a second decoder configured to decode the restoration data, and a data restorer configured to apply the restoration data to the up-scaled multimedia data to restore content.

The multimedia data may be 2D content data, the restoration data may be extracted by sequentially performing down-scaling, encoding, decoding, and up-scaling on the 2D content data and then subtracting result data from the 2D content data, and the data restorer may add the restoration data to the up-scaled 2D content data to restore original 2D content data.

The multimedia data may be one of left eye image data and right eye image data contained in 3D content, the restoration data may be extracted by sequentially performing down-scaling, encoding, decoding, and up-scaling on one of the left eye image data and right eye image data contained in the 3D content and then subtracting result data from another one of the left eye image data and the right eye image data, and the data restorer may add the restoration data to one of the up-scaled left eye image data and right eye image contained in the 3D content to restore another one of the left eye image data and the right eye image data.

The first transmission network may be a radio frequency (RF) network, and the second transmission network may be an Internet protocol (IP) network.

According to another aspect of the present invention, a transmitting method of a transmitting apparatus includes down-scaling multimedia data, encoding the down-scaled multimedia data, transmitting the encoded multimedia data through a first transmission network, decoding the encoded multimedia data, up-scaling the decoded multimedia data, generating restoration data using the up-scaled multimedia data, encoding the restoration data, and transmitting the encoded restoration data through a second transmission network.

The multimedia data may be 2D content data, and the generating of the restoration data may include comparing the 2D content data and the up-scaled 2D content data to generate a comparison result as the restoration data.

The multimedia data may be one of left eye image data and right eye image data contained in 3D content, and the generating of the restoration data may include comparing another one of the left eye image data and the right eye image data with the up-scaled multimedia data to generate a comparison result as the restoration data.

According to another aspect of the present invention, a receiving apparatus of a receiving apparatus includes receiving multimedia data transmitted through a first transmission network, decoding the received multimedia data, up-scaling the decoded multimedia data, receiving restoration data transmitted through a second transmission network, decoding the restoration data, and restoring content by applying the restoration data to the up-scaled multimedia data.

The multimedia data may be 2D content data, the restoration data may be extracted by sequentially performing down-scaling, encoding, decoding, and up-scaling on the 2D content data and then subtracting result data from the 2D content data, and the restoring of the content may include adding the restoration data to the up-scaled 2D content data to restore the 2D content data.

The multimedia data may be one of left eye image data and right eye image data contained in 3D content, the restoration data is extracted by sequentially performing down-scaling, encoding, decoding, and up-scaling on one of the left eye image data and right eye image data contained in the 3D content and then subtracting result data from another one of the left eye image data and the right eye image data, and the restoring of the content may include adding the restoration data to one of the up-scaled left eye image data and right eye image contained in the 3D content to restore another one of the left eye image data and the right eye image data.

According to another aspect of the present invention, a content processing apparatus includes a down-scaler configured to down-scale multimedia data, a first encoder configured to encode the down-scaled multimedia data, a decoder configured to decode the encoded multimedia data, an up-scaler configured to up-scale the decoded multimedia data, a restoration data generator configured to generate restoration data using the up-scaled multimedia data, and a second encoder configured to encode the restoration data.

### EFFECT OF THE INVENTION

According to various embodiments of the present invention, different data may be transmitted and received through respective different paths using an existing equipment to overcome transmission bandwidth limitation, thereby providing new content to a user.

In addition, even if data may not be received through a second transmission network and a reception environment of the second transmission network is poor, new content may be provided to the user.

### BRIEF DESCRIPTION OF THE DRAWING FIGURES

FIG. 1 is a diagram illustrating a multimedia data transceiving system according to an embodiment of the present invention.
FIG. 2 is a block diagram of a multimedia data transceiving system according to an embodiment of the present invention.
FIG. 3 is a block diagram illustrating a structure of a transmitting apparatus according to an embodiment of the present invention.
FIG. 4 is a block diagram illustrating a structure of a receiving apparatus according to an embodiment of the present invention.
FIG. 5 is a block diagram illustrating a structure of a transmitting apparatus according to another embodiment of the present invention.
FIG. 6 is a block diagram illustrating a structure of a receiving apparatus according to another embodiment of the present invention.
FIG. 7 is a block diagram illustrating a structure of a transmitting apparatus according to another embodiment of the present invention.
FIG. 8 is a diagram for explanation of data transmitted through a first transmission network and a second transmission network.
FIG. 9 is a block diagram illustrating a structure of a receiving apparatus according to another embodiment of the present invention.
FIG. 10 is a diagram of a multimedia data transceiving system according to another embodiment of the present invention.
FIG. 11 is a flowchart of a transmitting method according to an embodiment of the present invention.
FIG. 12 is a flowchart of a receiving method according to an embodiment of the present invention.

### DETAILED DESCRIPTION OF THE EXEMPLARY EMBODIMENTS

Certain exemplary embodiments of the present invention will now be described in greater detail with reference to the accompanying drawings.

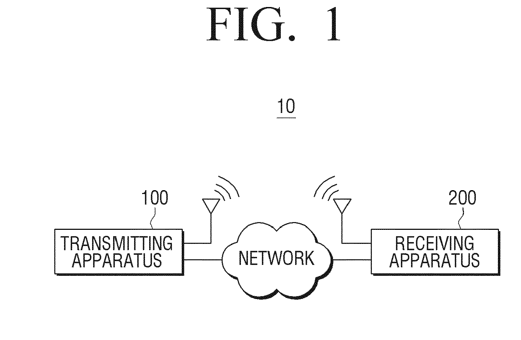

FIG. 1 is a diagram illustrating a multimedia data transceiving system 10 according to an embodiment of the present invention. Referring to FIG. 1, the multimedia data transceiving system 10 includes a transmitting apparatus 100 and a receiving apparatus 200.

The transmitting apparatus 100 processes multimedia data and transmit signals through respective different transmission networks. For example, as illustrated in FIG. 1, the transmitting apparatus 100 may transmit a first signal through a first transmission network and transmit a second signal through a second transmission network.

The first signal and the second signal may be different multimedia data constituting one multimedia data or multimedia data and restoration data for restoring the multimedia data. For example, when the multimedia data is 3D content, a left eye image or a right eye image may be transmitted through the first transmission network and restoration data for restoration of another image may be transmitted through the second transmission network.

Here, the first transmission network may be a radio frequency (RF) network and the second transmission network may be an Internet protocol (IP) network. However, this is purely exemplary. Thus, the first transmission network may be an IP network and the second transmission network may be an RF network, or the first transmission network and the second transmission network may be the same type of network.

The receiving apparatus 200 may receive the first signal and second signal transmitted from the transmitting apparatus 100 and process data to reproduce multimedia data.

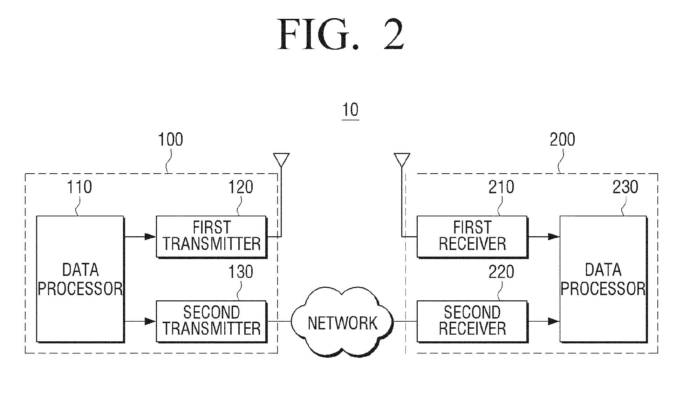

FIG. 2 is a block diagram of the multimedia data transceiving system 10 according to an embodiment of the present invention. Referring to FIG. 2, the transmitting apparatus 100 of the multimedia data transceiving system 10 includes a data processor 110, a first transmitter 120, and a second transmitter 130.

The data processor 110 signal-processes multimedia data and transmits the signal-processed multimedia data and restoration data to the first transmitter 120 and the second transmitter 130. The first transmitter 120 transmits the signal-processed multimedia data to the receiving apparatus 200 through the first transmission network. To this end, the first transmitter 120 may convert the signal-processed multimedia data into a form appropriate for a transmission standard of the first transmission network.

The second transmitter 130 transmits the signal-processed multimedia data or the restoration data to the receiving apparatus 200 through the second transmission network. To this end, the second transmitter 130 may convert the signal-processed multimedia data or the restoration data into a form appropriate for a transmission standard of the second transmission network.

Here, when the multimedia data is 3D content, a left eye image or a right eye image may be transmitted through the first transmission network and restoration data for restoration of another image may be transmitted through the second transmission network. Alternatively, the left eye image or the right eye image is transmitted through the first transmission network and another image may be transmitted through the second transmission network. When the multimedia data is 2D content, down-scaled 2D content may be transmitted through the first transmission network and restoration data for restoring the original 2D content may be transmitted through the second transmission network.

In addition, some of data to be transmitted through the second transmission network may be transmitted through the first transmission network. For example, when a left eye image and right eye image of 3D content are transmitted through the first transmission network and the second transmission network, respectively, some frames of the right eye image transmitted through the second transmission network may be transmitted through the first transmission network. Thus, even if delay, loss, and so on occur in data transmitted through the second transmission network, 3D content may be reproduced using data transmitted through the first transmission network.

The receiving apparatus 200 of the multimedia data transceiving system 10 includes a first receiver 210, a second receiver 220, and a data processor 230.

The first receiver 210 receives the multimedia data from the transmitting apparatus 100 through the first transmission network. The second receiver 220 receives the multimedia data or the restoration data from the transmitting apparatus 100 through the second transmission network. The data processor 230 signal-processes the multimedia data or restoration data received through the first receiver 210 and the second receiver 220 so as to output the original content through an output unit (not shown).

Hereinafter, operations of the transmitting apparatus 100 and the receiving apparatus 200 will be described in detail with regard to various embodiments of the present invention.

### <Embodiment of transmitting 2D content and restoration data>

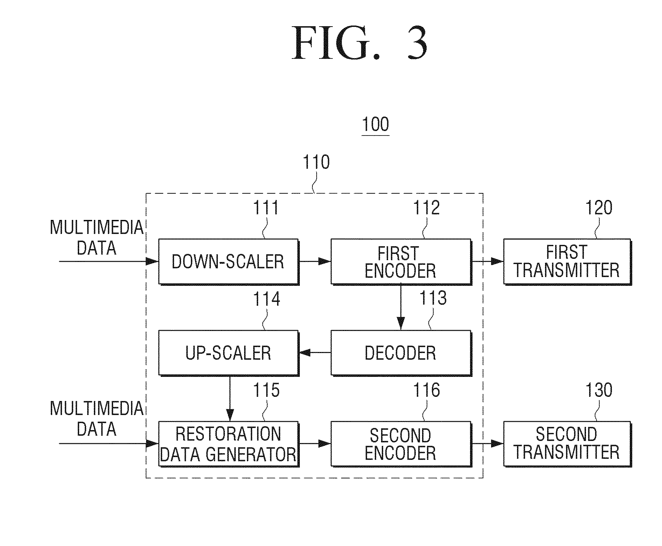

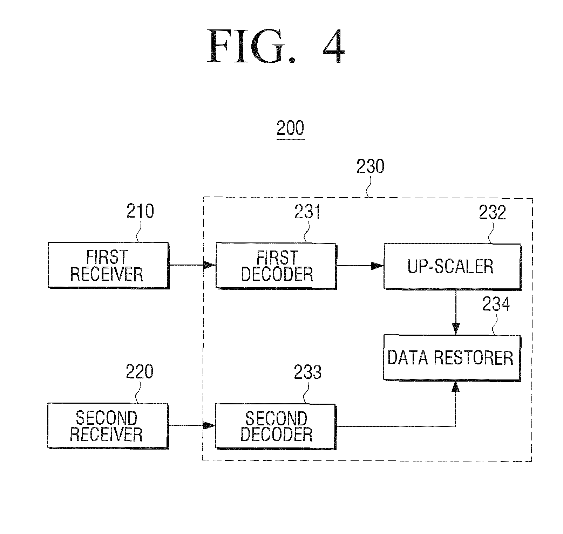

An embodiment of transceiving 2D content and restoration data will be described in detail with reference to FIGs. 3 and 4. Here, 2D content may be a 2D image of ultra high definition (UHD) image quality, a multi-angle image, and so on.

FIG. 3 is a block diagram illustrating a structure of the transmitting apparatus 100 according to an embodiment of the present invention. Referring to FIG. 3 the transmitting apparatus 100 includes a down-scaler 111, a first encoder 112, a decoder 113, an up-scaler 114, a restoration data generator 115, a second encoder 116, the first transmitter 120, and the second transmitter 130.

When original 2D content data is input to the down-scaler 111, the down-scaler 111 down-scales the input data. With regard to a large amount of data such as data with UHD image quality, original data may not be frequently transmitted through one transmission channel. In this case, a data size may be reduced via downscaling.

The first encoder 112 encodes down-scaled 2D content data. In detail, the first encoder 112 may perform MPEG-2 encoding on the down-scaled 2D content data for compatibility with an existing receiver. However, an image format to be encoded by the first encoder 112 is not limited thereto. The encoding may be performed according to a currently available image forma such as H.264, HEVC, and so on, and various image formats to be developed in the future and to be applied to the embodiments of the present invention.

The first transmitter 120 transmits the 2D content data encoded by the first encoder 112 to the receiving apparatus 200. The first transmitter 120 may perform an additional process on the encoded 2D content data so as to be appropriate for a transmission network and transmit the 2D content data to the receiving apparatus 200. For example, when the first transmission network is an RF network, the first transmitter 120 may include a modulator (not shown), an upconverter (not shown), and so on, and perform modulation, upconverting, and so on in order to transmit an RF signal.

The decoder 113 decodes the 2D content data encoded by the first encoder 112. In detail, the decoder 113 may perform a reverse process of the first encoder 112 to decode the 2D content data.

The up-scaler 114 up-scales the decoded 2D content data. Thus, the up-scaler 114 may restore the 2D content data to an original size thereof.

The restoration data generator 115 receives the original 2D content data and the 2D content data up-scaled by the up-scaler 114 to generate restoration data. The original 2D content data may be down-scaled and encoded by the down-scaler 111 and the first encoder 112 in order to transmit the original 2D content data through the first transmission network. In addition, even if the data is restored via decoding and upscaling, errors may occur. The restoration data generator 115 may compare the original 2D content data and 2D content data that is up-scaled and input from the up-scaler 114 to generate the comparison result as restoration data. That is, the restoration data may be error data that is generated while the original 2D content data is down-scaled, encoded, decoded, and up-scaled.

The restoration data generator 115 may include a subtracter for generating the restoration data. That is, 2D content data input from the up-scaler 114 may be subtracted from the original 2D content data to generate the restoration data.

The second encoder 116 encodes the restoration data generated by the restoration data generator 115. In detail, the second encoder 116 may perform HEVC encoding on the restoration data. However, an image format encoded by the second encoder 116 is not limited thereto. That is, the encoding may be performed in current available image formats such as MPEG-2, H.264, etc. and various image formats to be developed in the future and applied to embodiments of the present invention.

The second transmitter 130 transmits the restoration data encoded by the second encoder 116 to the receiving apparatus 200. For example, when the second transmission network is an Internet protocol (IP) network, the first transmitter 120 may transmit the encoded restoration data to the receiving apparatus 200 via the Internet.

FIG. 4 is a block diagram illustrating a structure of the receiving apparatus 200 according to an embodiment of the present invention. Referring to FIG. 4, the receiving apparatus 200 includes the first receiver 210, the second receiver 220, a first decoder 231, an up-scaler 232, a second decoder 233, and a data restorer 234.

The first receiver 210 receives 2D content data through the first transmission network. When the first transmission network is an RF network, the first receiver 210 may be configured by including an antenna, a tuner, a demodulator, an equalizer, and so on. The structures and operations of the antenna, the tuner, the demodulator, the equalizer, and so on. are disclosed in various known broadcast standards, and thus, a detailed description thereof will not be given here.

The first decoder 231 decodes 2D content data received from the first receiver 210. In detail, the first decoder 231 may perform a reverse process of the first encoder 112 of the transmitting apparatus 100 according to a compression image format to decode the 2D content data. For example, when the 2D content data is MPEG-2 encoded, MPEG-2 decoding may be performed.

The up-scaler 232 up-scales the decoded 2D content data. The up-scaler 232 may restore the 2D content data down-scaled by the transmitting apparatus 100 to an original data size.

The second receiver 220 receives the restoration data through the second transmission network. When the second transmission network is an IP network, the second receiver 220 may receive the restoration data in the form of an IP stream.

The second decoder 233 decodes the restoration data received from the second receiver 220. In detail, the second decoder 233 may perform a reverse process of the second encoder 116 of the transmitting apparatus 100 according to a compression image format to decode the restoration data. For example, when the 2D content data is HEVC encoded, HEVC decoding may be performed.

The data restorer 234 restores the original 2D content data. In detail, the data restorer 234 applies the restoration data decoded by the second decoder 233 to the 2D content data up-scaled by the up-scaler 232 and corrects errors generated during data processing processes of the transmitting apparatus 100 and the receiving apparatus 200 to restore the original 2D content data. To this end, the data restorer 234 may include an adder. That is, the data restorer 234 may add the restoration data to the up-scaled 2D content data to restore the original 2D content data.

According to another embodiment of the present invention, when the first encoder 112 uses codec to which an in-loop de-blocking filter is not applied, such as MPEG-2 codec, the transmitting apparatus 100 and the receiving apparatus 200 may further include a de-blocking filter (not shown) for block-artifact-filtering on the up-scaled data. That is, data output from the up-scaler 114 of the transmitting apparatus 100 may be block-artifact-filtered by the de-blocking filter (not shown) and then input to the restoration data generator 115. In addition, data output from the up-scaler 232 of the receiving apparatus 200 may be block-artifact-filtered by a deblocking filter (not shown) and then input to the data restorer 234. Thus, errors due to block noise of MPEG-2 may be reduced and a data size of the restoration data may be reduced.

In addition, when multimedia data has a data size so as to be transmitted using only a bandwidth of an existing transmission channel without being down-scaled, the down-scaler 111 and the up-scalers 114 and 232 may be omitted from the transmitting apparatus 100 and the receiving apparatus 200.

### <Embodiment of transmitting any one of left eye image and right eye image of 3D content and restoration data >

An embodiment of transceiving 3D content and restoration data will be described in detail with reference to FIGs. 3 and 4. The embodiment of transceiving 3D content and restoration data has the same configuration as the embodiment of transceiving 2D content and restoration data, except for target transceived data, and thus, a detailed description thereof is not repeated here.

FIG. 3 is a block diagram illustrating a structure of the transmitting apparatus 100 according to an embodiment of the present invention. Referring to FIG. 3, the transmitting apparatus 100 includes the down-scaler 111, the first encoder 112, the decoder 113, the up-scaler 114, the restoration data generator 115, the second encoder 116, the first transmitter 120, and the second transmitter 130.

When one of left eye image and right eye image data constituting 3D content data is input to the down-scaler 111, the down-scaler 111 down-scales the input data.

The first encoder 112 encodes the down-scaled left eye image or right eye image data. In detail, the first encoder 112 may perform MPEG-2 on the down-scaled 2D content data for compatibility with an existing receiver.

The first transmitter 120 transmits the left eye image or right eye image data encoded by the first encoder 112 to the receiving apparatus 200.

The decoder 113 decodes the left eye image or right eye image data encoded by the first encoder 112.

The up-scaler 114 may up-scale the decoded left eye image or right eye image data to restore an original data size.

The restoration data generator 115 receives the left eye image or right eye image data up-scaled by the up-scaler 114 and another one of the left eye and the right eye image constituting the 3D content data to generate restoration data.

In detail, the restoration data generator 115 may compare the up-scaled left eye image or right eye image data and another one of the left eye image and right eye image constituting 3D content data to generate the comparison result as the restoration data. To this end, the restoration data generator 115 may include a subtracter. That is, any one of the left eye image and right eye image input from the up-scaler 114 may be subtracted from any one of the original left eye image and right eye image data constituting the 3D content data to generate the restoration data.

According to the aforementioned embodiment, in order to generate the restoration data by the restoration data generator 115, the up-scaled left eye image or right eye image is used. Alternatively, the restoration data generator 115 may generate the restoration data using the original left eye image and right eye image. In this case, the decoder 113 and the up-scaler 114 of the data processor 110 may be omitted.

The second encoder 116 encodes the restoration data generated by the restoration data generator 115.

The second transmitter 130 transmits the restoration data encoded by the second encoder 116 to the receiving apparatus 200.

FIG. 4 is a block diagram of the receiving apparatus 200 according to an embodiment of the present invention. Referring to FIG. 4, the receiving apparatus 200 includes the first receiver 210, the second receiver 220, the first decoder 231, the up-scaler 232, the second decoder 233, and the data restorer 234.

The first receiver 210 receives any one of left eye image and right eye image data constituting 3D content through the first transmission network.

The first decoder 231 decodes the data received from the first receiver 210. In detail, the first decoder 231 may perform a reverse process of the first encoder 112 of the transmitting apparatus 100 according to a compression image format to decode the left eye image or right eye image data.

The up-scaler 232 may up-scale the decoded left eye image or right eye image data to restore the left eye image or right eye image data down-scaled by the transmitting apparatus 100 to an original data size.

The second receiver 220 receives restoration data through the second transmission network. When the second transmission network is an IP network, the second receiver 220 may receive the restoration data in the form of an IP stream.

The second decoder 233 decodes the restoration data received from the second receiver 220. In detail, the second decoder 233 may perform a reverse process of the second encoder 116 of the transmitting apparatus 100 according to a compression image format to decode the restoration data.

The data restorer 234 restores one of the left eye image and right eye image data of the 3D content. In detail, the data restorer 234 may apply the restoration data decoded by the second decoder 233 to the left eye image or right eye image data up-scaled by the up-scaler 232 to restore another one of the left eye image and right eye image data. To this end, the data restorer 234 may include an adder. That is, the data restorer 234 may add the restoration data to the up-scaled left eye image or right eye image data to restore another one of the left eye image and right eye image data.

Here, the left eye image and right eye image of the 3D content output from the up-scaler 232 and the data restorer 234 may be output from an output unit (not shown).

According to another embodiment of the present invention, when the first encoder 112 uses codec to which an in-loop de-blocking filter is not applied, such as MPEG-2 codec, the transmitting apparatus 100 and the receiving apparatus 200 may further include a de-blocking filter (not shown) for block-artifact-filtering on the up-scaled data. That is, data output from the up-scaler 114 of the transmitting apparatus 100 may be block-artifact-filtered by the de-blocking filter (not shown) and then input to the restoration data generator 115. In addition, data output from the up-scaler 232 of the receiving apparatus 200 may be block-artifact-filtered by a deblocking filter (not shown) and then input to the data restorer 234. Thus, errors due to block noise of MPEG-2 may be reduced and a data size of the restoration data may be reduced.

In addition, when multimedia data has a data size so as to be transmitted using only a bandwidth of an existing transmission channel without being down-scaled, the down-scaler 111 and the up-scalers 114 and 232 may be omitted from the transmitting apparatus 100 and the receiving apparatus 200.

### <Embodiment of transmitting left eye image and right eye image data of 3D content>

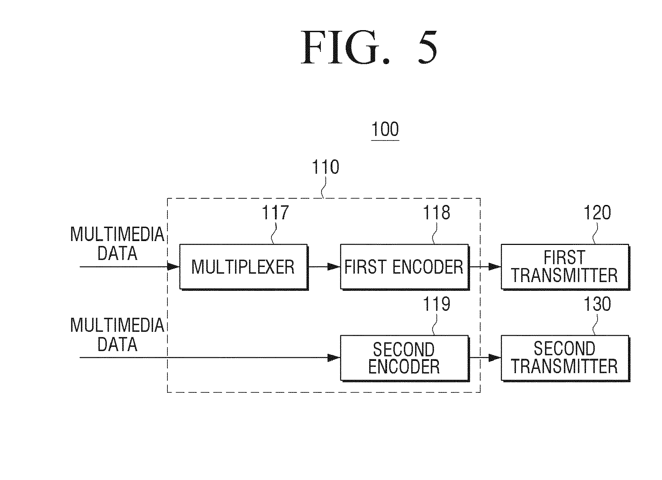

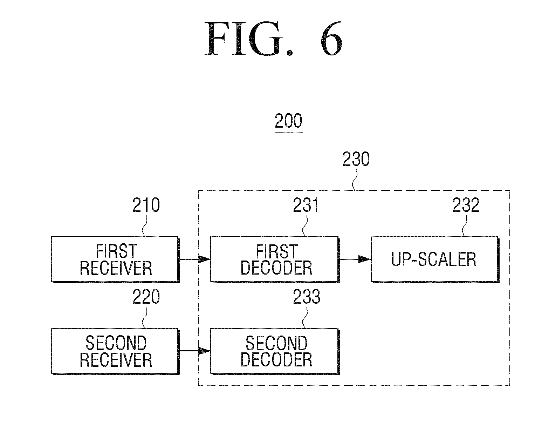

An embodiment of transceiving left eye image and right eye image data of 3D content will be described in detail with reference to FIGs. 5 and 6.

FIG. 5 is a block diagram illustrating a structure of the transmitting apparatus 100 according to another embodiment of the present invention. Referring to FIG. 5, the transmitting apparatus 100 includes the down-scaler 111, the first encoder 112, the second encoder 116, the first transmitter 120, and the second transmitter 130.

When one of left eye image and right eye image data constituting 3D content data is input to the down-scaler 111, the down-scaler 111 down-scales the input data. With regard to a large amount of data such as data with UHD image quality, original data may not be frequently transmitted through one transmission channel. In this case, a data size may be reduced via downscaling.

The first encoder 112 encodes the down-scaled left eye image or right eye image data. In detail, the first encoder 112 may perform MPEG-2 on the down-scaled 2D content data for compatibility with an existing receiver. However, an image format to be encoded by the first encoder 112 is not limited thereto. The encoding may be performed according to a currently available image forma such as H.264, HEVC, and so on, and various image formats to be developed in the future and to be applied to the embodiments of the present invention.

The first transmitter 120 transmits the left eye image or right eye image data encoded by the first encoder 112 to the receiving apparatus 200. The first transmitter 120 may perform an additional process on the encoded left eye image or right eye image data so as to be appropriate for a transmission network and transmit the data to the receiving apparatus 200. For example, when the first transmission network is an RF network, the first transmitter 120 may include a modulator (not shown), an upconverter (not shown), and so on, and perform modulation, upconverting, and so on in order to transmit an RF signal.

The second encoder 116 receives and encodes another one of the left eye image and right eye image data of the 3D content. In detail, the second encoder 116 may perform HEVC encoding on another one of the left eye image and right eye image data of the 3D content. However, an image format encoded by the second encoder 116 is not limited thereto. That is, the encoding may be performed in current available image formats such as MPEG-2, H.264, etc. and various image formats to be developed in the future and applied to embodiments of the present invention.

The second transmitter 130 transmits another one of the left eye image and right eye image data of the 3D content encoded by the second encoder 116 to the receiving apparatus 200. For example, when the second transmission network is an Internet protocol (IP) network, the second transmitter 130 may transmit the encoded data to the receiving apparatus 200 via the Internet.

FIG. 6 is a block diagram illustrating a structure of the receiving apparatus 200 according to another embodiment of the present invention. The receiving apparatus 200 of FIG. 6 is the same as the receiving apparatus 200 of FIG. 4, except for presence of the data restorer 234, and thus, a detailed description thereof is not repeated here. Referring to FIG. 6, the receiving apparatus 200 includes the first receiver 210, the second receiver 220 the first decoder 231, the up-scaler 232, and the second decoder 233.

The first receiver 210 receives any one of left eye image and right eye image data constituting 3D content via the first transmission network.

The first decoder 231 decodes the data received from the first receiver 210. In detail, the first decoder 231 may perform a reverse process of the first encoder 112 of the transmitting apparatus 100 according to a compression image format to decode the left eye image or right eye image data.

The up-scaler 232 up-scales the decoded 2D content data. The up-scaler 232 may restore the left eye image or right eye image data down-scaled by the transmitting apparatus 100 to an original data size.

The second receiver 220 receives another one of the left eye image and right eye image data of the 3D content through the second transmission network. When the second transmission network is an IP network, the second receiver 220 may receive another one of the left eye image and right eye image data in the form of an IP stream.

The second decoder 233 decodes another one of the left eye image and right eye image data received from the second receiver 220. In detail, the second decoder 233 may perform a reverse process of the second encoder 116 of the transmitting apparatus 100 according to a compression image format to decode the data.

Here, the left eye image and right eye image data of the 3D content output from the up-scaler 232 and the second decoder 233 may be output from an output unit (not shown).

When multimedia data has a data size so as to be transmitted using only a bandwidth of an existing transmission channel without being down-scaled, the down-scaler 111 and the up-scaler 232 may be omitted from the transmitting apparatus 100 and the receiving apparatus 200.

### < Embodiment of transmitting first data and second data through first transmission network and transmitting second data through second transmission network>

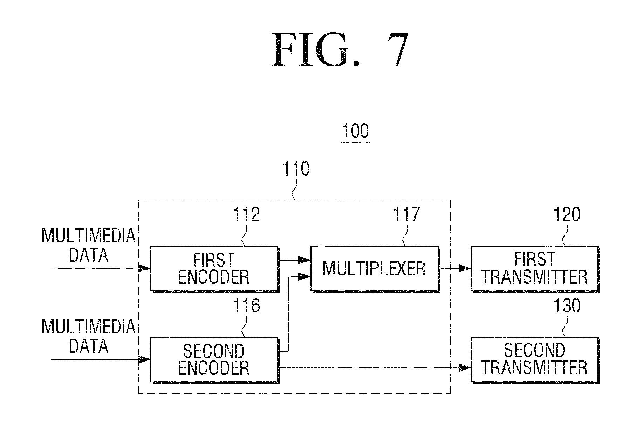

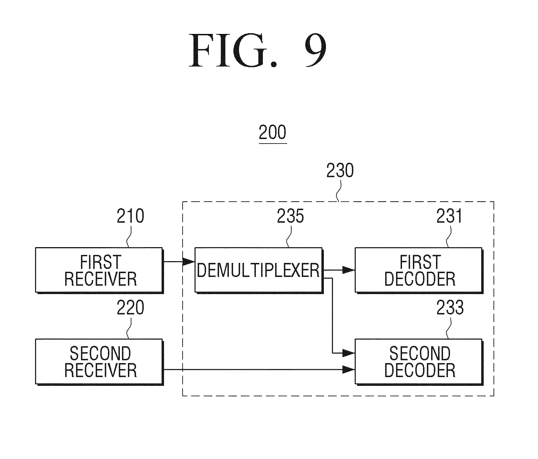

An embodiment of transmitting both first data and second data constituting one content through a first transmission network and transmitting the second data through a second transmission network will be described in detail with reference to FIGs. 7 and 9. Here, the first data and the second data may correspond to a left eye image and right eye image of 3D content, a plurality of images constituting multi-angle content, 2D data and depth image data, and so on.

FIG. 7 is a block diagram illustrating a structure of the transmitting apparatus 100 according to another embodiment of the present invention. Referring to FIG. 7, the transmitting apparatus 100 includes the first encoder 112, the second encoder 116, a multiplexer 117, the first transmitter 120, and the second transmitter 130.

The first encoder 112 encodes first data of a plurality of multimedia data constituting one content. In detail, the first encoder 112 may perform MPEG-2 on the first data for compatibility with an existing receiver. However, an image format to be encoded by the first encoder 112 is not limited thereto. The encoding may be performed according to a currently available image forma such as H.264, HEVC, and so on, and various image formats to be developed in the future and to be applied to the embodiments of the present invention.

The second encoder 116 encodes the second data of the plural multimedia data constituting one content. In detail, the second encoder 116 may perform HEVC encoding on the second data. However, an image format encoded by the second encoder 116 is not limited thereto. That is, the encoding may be performed in current available image formats having scalable properties, such as H.264, etc. and various image formats to be developed in the future and applied to embodiments of the present invention.

The multiplexer 117 multiplexes the first data encoded by the first encoder 112 and the second data encoded by the second encoder 116 to constitute one data.

The first transmitter 120 transmits the data multiplexed by the multiplexer 117 to the receiving apparatus 200. The first transmitter 120 may perform an additional process on the multiplexed data so as to be appropriate for a transmission network and transmit the data to the receiving apparatus 200. For example, when the first transmission network is an RF network, the first transmitter 120 may include a modulator (not shown), an upconverter (not shown), and so on, and perform modulation, upconverting, and so on in order to transmit an RF signal.

The second transmitter 130 transmits the second data encoded by the second encoder 116 to the receiving apparatus 200. For example, when the second transmission network is an IP network, the second transmitter 130 may transmit the encoded data to the receiving apparatus 200 via the Internet.

Thus, even if an existing receiving apparatus does not support data reception via the second transmission network or does not smoothly perform data reception through the second transmission network, the receiving apparatus may receive the first data and the second data through the first transmission network and provide content including a plurality of data to a user.

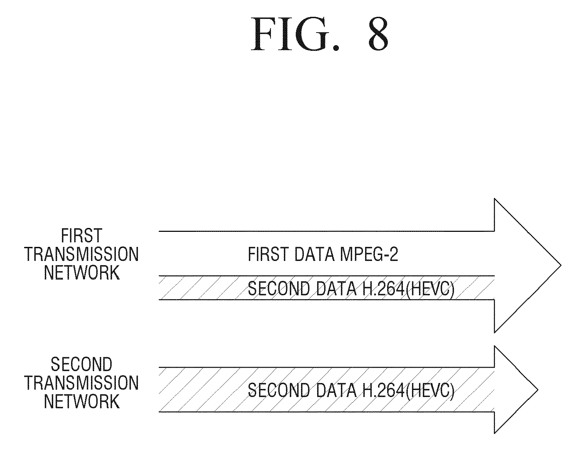

FIG. 8 is a diagram for explanation of data transmitted through a first transmission network and a second transmission network.

For example, when the first transmission network is an RF network and the second transmission network is an IP network, an existing RF broadcast channel may transmit data at a transmission speed of 19.83 Mbps. For example, when the first data is compressed in the format of MPEG-2 and the second data is compressed in the format of H.264, H.264 has compression efficiency two times greater than MPEG-2 format. With regard to data multiplexed according thereto, the first data may be transmitted at a speed of about 12 Mbps and the second data may be transmitted at a speed of about 6 Mbps. When the second data is encoded in the format of H.264, the second data may be transmitted at a speed of 6 Mbps through the second transmission network.

FIG. 9 is a block diagram illustrating a structure of the receiving apparatus 200 according to another embodiment of the present invention. Referring to FIG. 9, the receiving apparatus 200 includes the first receiver 210, the second receiver 220, a demultiplexer 235, the first decoder 231, and the second decoder 233.

The first receiver 210 receives data obtained by multiplexing the first data and the second data through a first transmission network.

The second receiver 220 receives the second data through a second transmission network. When the second transmission network is an IP network, the second data may be received in the form of an IP stream.

The demultiplexer 235 may demultiplexes data received from the first receiver 210 into the first data and the second data and outputs the first data and the second data to the first decoder 231 and the second decoder 233, respectively.

The first decoder 231 decodes the first data input from the demultiplexer 235. In detail, the first decoder 231 may perform a reverse process of the first encoder 112 of the transmitting apparatus 100 according to a compression image format to decode the first data.

The second decoder 233 decodes the second data input from the demultiplexer 235. In detail, the second decoder 233may perform a reverse process of the second encoder 116 of the transmitting apparatus 100 according to a compression image format to decode the second data.

According to the aforementioned embodiment, the second data transmitted through the first transmission network and the second data transmitted through the second transmission network are the same. However, a size of data to be transmitted through the first transmission network is limited (for example, when the first transmission network is an RF network, the data may be transmitted at a maximum speed of 19.38 Mbps.). In addition, as the amount of the second data transmitted through the first transmission network is increased, the amount of the first data transmitted through the first transmission network may be reduced.

Accordingly, the amount of the second data transmitted through the first transmission network may be less than the amount of the second data transmitted through the second transmission network. For example, the first transmission network may transmit the first data at a transmission speed of about 16 Mbps and transmit the second data at a transmission speed of 2 Mbps.

To this end, the second encoder 116 may receive the second data, generate and encode relatively low image-quality data (hereinafter, referred to as base data) to be transmitted through the first transmission network and relatively high image-quality data (hereinafter, referred to as enhancement data) to be transmitted through the second transmission network, and then, output the relatively low image-quality data and the relatively high image-quality data to the multiplexer 117 and the second transmitter 130, respectively.

Alternatively, the second encoder 116 may generate, encode, and output data including the base data and additional information. In addition, the multiplexer 117 may selectively multiplex only the first data and the base data, and the second transmitter 130 may transmit the base data and additional information together.

As a method for reducing the amount of the second data transmitted through the first transmission network, some of a plurality of image frames constituting the second data may be transmitted (for example, content with a frame rate of 30 fps is transmitted at a frame rate of 15 fps), resolution of an image frame may be reduced (for example, HD image quality is converted into SD image quality or SD image quality is converted CIF image quality), or a bit rate of an image frame may be reduced (for example, 2 Mbps is converted into 512 kbps).

The receiving apparatus 200 according to the aforementioned embodiments may further include an output unit (not shown) for outputting multimedia data that is signal processed by the data processor 230. The output unit (not shown) may include an image output unit (not shown) for outputting image data and an audio output unit (not shown) for output audio data. Although the aforementioned embodiments have been described in terms of an image processor of the data processor 230, the data processor 230 may further include an audio processor (not shown) and an additional processor (not shown), for processing additional data and audio data contained in the received multimedia data. The audio processor (not shown) may process audio data to output the audio data through the audio output unit, and the additional data processor (not shown) may process additional data such as subtitles and render image data to form an image. Then, the form image may be output through a display unit.

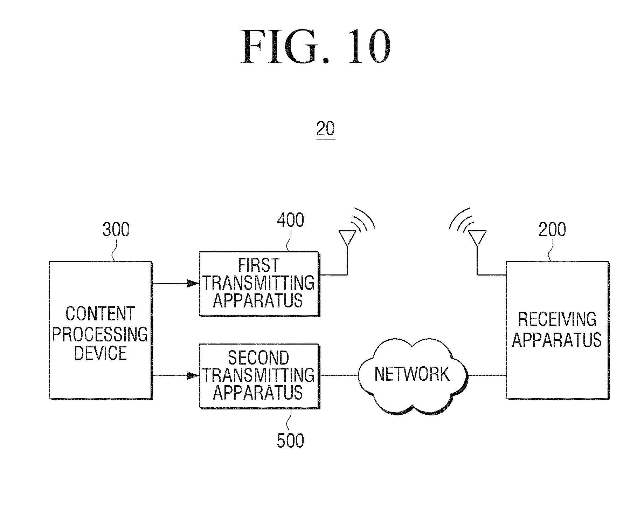

FIG. 10 is a diagram of a multimedia data transceiving system 20 according to another embodiment of the present invention. The transceiving system 20 is the same as the transceiving system 10 of FIGS. 1 and 2 in terms of an operation thereof, except that the transmitting apparatus 100 of the transceiving system 10 is implemented as a transmitting system including a plurality of devices. Referring to FIG. 10, the transceiving system 20 includes a content processing device 300, a first transmitting apparatus 400, a second transmitting apparatus 500, and the receiving apparatus 200.

The content processing device 300 corresponds to the data processor 110 of the transmitting apparatus 100, the first transmitting apparatus 400 corresponds to the first transmitter 120 of the transmitting apparatus 100, and the second transmitting apparatus 500 corresponds to the second transmitter 130 of the transmitting apparatus 100, which will not be described here in detail.

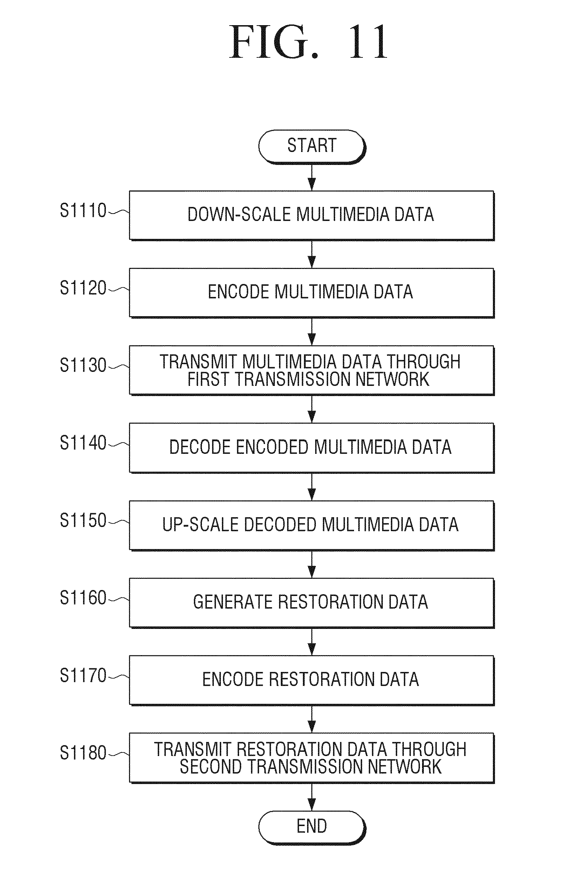

FIG. 11 is a flowchart of a transmitting method according to an embodiment of the present invention. Referring to FIG. 11, multimedia data is down-scaled (S1110). Here, the multimedia data may be one of 2D content data, and left eye image and right eye image data of 3D content. In addition, the down-scaled multimedia data is encoded (S1120). In detail, MPEG-2 encoding may be performed on the down-scaled multimedia data for compatibility with an existing receiver. Then, the encoded multimedia data is transmitted through a first transmission network (S1130). Here, the first transmission network may be an RF network.

In addition, the encoded multimedia data is decoded (S1140), and then the decoded multimedia data is up-scaled (S1150). In addition, restoration data is generated using the up-scaled multimedia data (S1160). When the multimedia data is 2D content data, 2D content data and the up-scaled 2D content data may be compared to generate restoration data as the comparison result. When the multimedia data is one of the left eye image and right eye image data contained in the 3D content, the multimedia data may be compared with up-scaled multimedia data of another one of the left eye image and right eye image data, and restoration data may be generated as the comparison result.

In addition, the restoration data is encoded (S1170) and is transmitted through the second transmission network (S1180). The second transmission network may be an IP network (Internet).

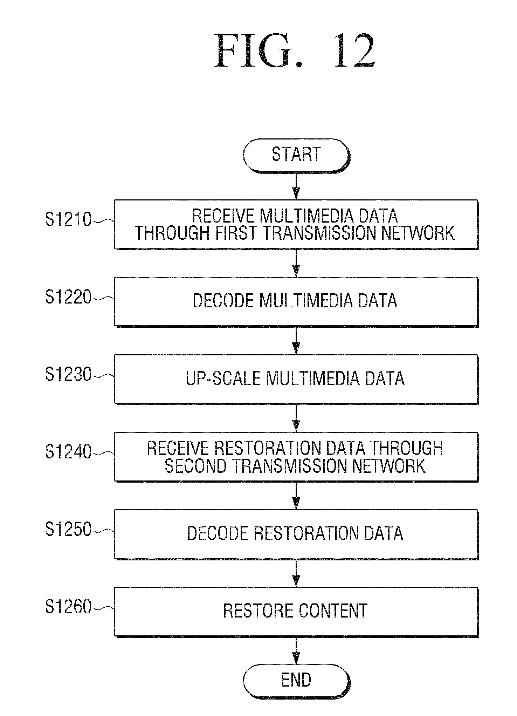

FIG. 12 is a flowchart of a receiving method according to an embodiment of the present invention. Referring to FIG. 12, multimedia data is received through a first transmission network (S1210). The first transmission network may be an RF network. In addition, the received multimedia data is decoded (S1220). Here, the multimedia data may be one of 2D content data, and left eye image and right eye image data of 3D content. Then, the decoded multimedia data is up-scaled (S 1230).

In addition, restoration data is received through a second transmission network (S1250). The second transmission network may be an IP network. The restoration data may be extracted by sequentially performing down-scaling, encoding, decoding, and up-scaling on 2D content data and subtracting result data from the 2D content data. Alternatively, the restoration data may be extracted by sequentially performing down-scaling, encoding, decoding, and up-scaling on one of left eye image data and right eye image data of 3D content and then subtracting result data from another one of the left eye image data and the right eye image data.

Then, the received restoration data is decoded (S1250) and the restoration data is applied to the up-scaled multimedia data to restore content (S1260). Here, when the multimedia data is 2D content data, the restoration data may be added to the up-scaled 2D content data to restore the 2D content data. When the multimedia data is one of left eye image and right eye image data contained in 3D content, the restoration data may be added to one of left eye image data and right eye image data of the up-scaled 3D content to restore another one of the left eye image data and the right eye image.

A program for execution of methods according to the aforementioned various embodiments of the present invention may be stored and used in various types of recording media.

In detail, a code for execution of the aforementioned methods may be stored in various types of non-volatile recording media such as a flash memory, a read only memory (ROM), an erasable programmable ROM (EPROM), an electronically erasable and programmable ROM (EEPROM), a hard disk, a removable disk, a memory card, a universal serial bus (USB) memory, a CD-ROM, and so on.

The foregoing exemplary embodiments and advantages are merely exemplary and are not to be construed as limiting the present invention. The present teaching can be readily applied to other types of apparatuses. Also, the description of the exemplary embodiments of the present invention is intended to be illustrative, and not to limit the scope of the claims, and many alternatives, modifications, and variations will be apparent to those skilled in the art.

## Claims

1. A transmitting apparatus comprising:
a down-scaler configured to down-scale multimedia data;
a first encoder configured to encode the down-scaled multimedia data;
a first transmitter configured to transmit the encoded multimedia data through a first transmission network;
a decoder configured to decode the encoded multimedia data;
an up-scaler configured to up-scale the decoded multimedia data;
a restoration data generator configured to generate restoration data using the up-scaled multimedia data;
a second encoder configured to encode the restoration data; and
a second transmitter configured to transmit the encoded restoration data through a second transmission network.

2. The transmitting apparatus as claimed in claim 1, wherein:
the multimedia data is 2D content data; and
the restoration data generator compares the 2D content data and the up-scaled 2D content data to generate a comparison result as the restoration data.

3. The transmitting apparatus as claimed in claim 1, wherein:
the multimedia data is one of left eye image data and right eye image data contained in 3D content; and
the restoration data generator compares another one of the left eye image data and the right eye image data with the up-scaled multimedia data to generate a comparison result as the restoration data.

4. The transmitting apparatus as claimed in claim 1, wherein:
the first transmission network is a radio frequency (RF) network; and
the second transmission network is an Internet protocol (IP) network.

5. A receiving apparatus comprising:
a first receiver configured to receive multimedia data transmitted through a first transmission network;
a first decoder configured to decode the received multimedia data;
an up-scaler configured to up-scale the decoded multimedia data;
a second receiver configured to receive restoration data transmitted through a second transmission network;
a second decoder configured to decode the restoration data; and
a data restorer configured to apply the restoration data to the up-scaled multimedia data to restore content.

6. The receiving apparatus as claimed in claim 5, wherein:
the multimedia data is 2D content data;
the restoration data is extracted by sequentially performing down-scaling, encoding, decoding, and up-scaling on the 2D content data and then subtracting result data from the 2D content data; and
the data restorer adds the restoration data to the up-scaled 2D content data to restore original 2D content data.

7. The receiving apparatus as claimed in claim 5, wherein:
the multimedia data is one of left eye image data and right eye image data contained in 3D content;
the restoration data is extracted by sequentially performing down-scaling, encoding, decoding, and up-scaling on one of the left eye image data and right eye image data contained in the 3D content and then subtracting result data from another one of the left eye image data and the right eye image data; and
the data restorer adds the restoration data to one of the up-scaled left eye image data and right eye image contained in the 3D content to restore another one of the left eye image data and the right eye image data.

8. The receiving apparatus as claimed in claim 1, wherein;
the first transmission network is a radio frequency (RF) network; and
the second transmission network is an Internet protocol (IP) network.

9. A transmitting method of a transmitting apparatus, the transmitting method comprising:
down-scaling multimedia data;
encoding the down-scaled multimedia data;
transmitting the encoded multimedia data through a first transmission network;
decoding the encoded multimedia data;
up-scaling the decoded multimedia data;
generating restoration data using the up-scaled multimedia data;
encoding the restoration data; and
transmitting the encoded restoration data through a second transmission network.

10. The transmitting method as claimed in claim 9, wherein:
the multimedia data is 2D content data; and
the generating of the restoration data comprises comparing the 2D content data and the up-scaled 2D content data to generate a comparison result as the restoration data.

11. The transmitting method as claimed in claim 9, wherein:
the multimedia data is one of left eye image data and right eye image data contained in 3D content; and
the generating of the restoration data comprises comparing another one of the left eye image data and the right eye image data with the up-scaled multimedia data to generate a comparison result as the restoration data.

12. A receiving apparatus of a receiving apparatus, the receiving method comprising:
receiving multimedia data transmitted through a first transmission network;
decoding the received multimedia data;
up-scaling the decoded multimedia data;
receiving restoration data transmitted through a second transmission network;
decoding the restoration data; and
restoring content by applying the restoration data to the up-scaled multimedia data.

13. The receiving apparatus as claimed in claim 12, wherein:
the multimedia data is 2D content data;
the restoration data is extracted by sequentially performing down-scaling, encoding, decoding, and up-scaling on the 2D content data and then subtracting result data from the 2D content data; and
the restoring of the content comprises adding the restoration data to the up-scaled 2D content data to restore the 2D content data.

14. The receiving apparatus as claimed in claim 12, wherein:
the multimedia data is one of left eye image data and right eye image data contained in 3D content;
the restoration data is extracted by sequentially performing down-scaling, encoding, decoding, and up-scaling on one of the left eye image data and right eye image data contained in the 3D content and then subtracting result data from another one of the left eye image data and the right eye image data; and
the restoring of the content comprises adding the restoration data to one of the up-scaled left eye image data and right eye image contained in the 3D content to restore another one of the left eye image data and the right eye image data.

15. A content processing apparatus comprising:
a down-scaler configured to down-scale multimedia data;
a first encoder configured to encode the down-scaled multimedia data;
a decoder configured to decode the encoded multimedia data;
an up-scaler configured to up-scale the decoded multimedia data;
a restoration data generator configured to generate restoration data using the up-scaled multimedia data; and
a second encoder configured to encode the restoration data.
